# EUROPÄISCHE PATENTSCHRIFT

(11) **EP 3 562 574 B1**
(45) Veröffentlichungstag und Bekanntmachung des Hinweises auf die Patenterteilung: **10.07.2024**
(21) Anmeldenummer: 17837888.1
(22) Anmeldetag: 28.12.2017
(51) Int. Cl.: B01D 61/42, B01D 67/00, B01D 71/68, C23C 16/04

(54) **VERFAHREN ZUR SEPARATION VON GELADENEN SUBSTANZEN AUS FLÜSSIGKEITEN UND DEREN WIEDERGEWINNUNG**
METHOD FOR SEPARATING CHARGED SUBSTANCES FROM LIQUIDS AND THE RECOVERY THEREOF
PROCÉDÉ POUR LA SÉPARATION DE SUBSTANCES CHARGÉES À PARTIR DE LIQUIDES ET LEUR RECOUVREMENT

(30) Priorität: 28.12.2016 DE 102016125818
(43) Veröffentlichungstag der Anmeldung: 06.11.2019
(60) Teilanmeldung: 20211873.3
(73) Patentinhaber: i3 Membrane GmbH, 22761 Hamburg (DE)
(72) Erfinder: BRINKE-SEIFERTH, Stephan, 22607 Hamburg (DE)
(74) Vertreter: Raffay & Fleck
(86) Internationale Anmeldenummer: PCT/EP2017/084721
(87) Internationale Veröffentlichungsnummer: WO 2018/122315

(56) Entgegenhaltungen:
- EP-A1- 2 087 916
- EP-A1- 3 115 099
- WO-A1-99/22843
- SPIETELUN AGATA ET AL: "Recent developments and future trends in solid phase microextraction techniques towards green analytical chemistry", JOURNAL OF CHROMATOGRAPHY A, vol. 1321, 17 October 2013 (2013-10-17), pages 1 - 13, XP028785488, ISSN: 0021-9673, DOI: 10.1016/J.CHROMA.2013.10.030
- LOH I-H ET AL: "ELECTRICALLY CONDUCTIVE MEMBRANES: SYNTHESIS AND APPLICATIONS", JOURNAL OF MEMBRANE SCIENCE, ELSEVIER BV, NL, vol. 50, no. 1, 1 May 1990 (1990-05-01), pages 31 - 49, XP000159695, ISSN: 0376-7388, DOI: 10.1016/S0376-7388(00)80884-4

## Beschreibung

Die vorliegende Erfindung betrifft ein Verfahren zum zumindest temporären Rückhalt von geladenen biologisch aktiven Substanzen, beispielsweise Endotoxinen, Viren, Proteinen aus Flüssigkeiten, und möglichen späteren Freisetzung zur besseren Bestimmung.

Endotoxine sind Lipopolysaccharide (LPS) und Bestandteile der äußeren Membran der Zellwand gram-negativer Bakterien. Sie bestehen aus einem lipophilen und in der Membran verankerten Lipid sowie einem hydrophilen Polysaccharid, das für die antigenen Eigenschaften steht. Endotoxine werden bei Lyse der Bakterienzelle freigesetzt. Sie sind extrem hitzestabil und können selbst nach der Sterilisation, sprich nach Abtöten der Bakterien noch nachgewiesen werden. Wegen ihrer Fähigkeit, eine Immunreaktion zu induzieren, gehören Endotoxine zu den Pyrogenen. Endotoxine in der Menge von 1 ng/kg Körpergewicht gelten bereits als ausreichend für das Auslösen einer fieberhaften Reaktion (ARDUINO (1989)). Neben Fieber als Folge von Entzündungen können sie beim Menschen nach Kontakt mit Schleimhäuten und besonders beim Übertritt in die Blutbahn zahlreiche physiologische Reaktionen auslösen. Hier sind Blutdruckabfall, Blutgerinnungs- und Komplementaktivierung sowie lebensbedrohende Schockzustände zu nennen.

Endotoxine werden gewöhnlich im Kaninchen oder im Limulus-Amöbozyten-Lysat (LAL)-Test nachgewiesen. Der LAL-Test basiert auf dem Blut des Pfeilschwanzkrebses, welches in seiner Färbung äußerst sensitiv auf Endotoxine von gram negativen Bakterien reagiert. Aufgrund der Sensitivität ist der LAL-Test der am meisten genutzte Test im pharmakologischen und medizinischen Umfeld. Allerdings lassen sich Endotoxine mit diesem Test nur in klaren ungefärbten Flüssigkeiten bestimmen. Eine direkte Bestimmung von Endotoxinen im Blut vorn Menschen ist daher nicht möglich. Daher wurde in den vergangenen Jahren der sogenannte Monozyten-Aktivierungstest entwickelt. Dieser funktioniert über verschiedene Stufen von enzymatischen Reaktionen, die der Fieberreaktion von Menschen nachgebildet sind. Es bedarf auch bei jeder Bestimmung einer Erstellung einer Standartkurve, da die Reaktanten jedes Test-Kids unterschiedlich reagieren. Dieser Test bedarf einer speziellen Ausbildung und er weist hohe spezifische Kosten auf und dauert zudem sehr viel länger als der LAL Test.

Mikroporöse Membranen sind seit langer Zeit bekannt. Diese werden vornehmlich aus Polymeren gefertigt und zur Wasseraufbereitung (Abwasser, Trinkwasser, Industriewässer) als auch in der Pharmaindustrie zur Herstellung von ultrareinem Wasser als auch in der Medizintechnik als Sterilfilter oder Atemfilter eingesetzt. Die Einsatzbereiche sind vielfach und sehr divergent. Mikroporöse Membranen haben in der Regel eine Porengrö-ße zwischen 0,01 µm und 10 µm und halten entsprechend dieser Porengrößen Stoffe zurück.

Mikroporöse Filter werden typischerweise eingesetzt, um in Wasser gelöste Stoffe zu separieren und ein klares Filtrat zu erhalten. Dies geschieht in der Regel mechanisch über die Porengröße. Alle Stoffe, die größer sind als die Größe der Poren, werden mechanisch zurückgehalten. Neben dieser Eigenschaft gibt es noch einen weiteren Mechanismus, der zum Rückhalt von Stoffen bei dem Passieren der Membran stattfindet. Es handelt sich hierbei um eine nicht definierte Adsorption durch die Materialien, aus denen die Membran selbst besteht, wie beispielsweise Polyethersulfon, Polypropylen oder Polyvenylidenflouorid (PVDF). Dabei adsorbieren unterschiedliche Materialien unterschiedlich stark verschiedene gelöste Stoffe ("Analyte Loss Due to Membrane Filter Adsorption as Determined by High-Performance Liquid Chromatography" M. Carlson and R.D. Thompson, Journal of Chromatographic Science, Vol. 38, Feb. 2000).

Eine gerichtete Adsorption von Stoffen, die kleiner als die Porengröße der mikroporösen Membran, mittels der Materialeigenschaften des Membranmaterials wird durch die Behandlung der chemischen Komposition des Membranmaterials erreicht. Eine positive Ladung wird beispielsweise durch Verbindung des Membranmaterials mit positiv geladenen quaternären Ammoniumverbindungen erzeugt. Positiv geladene Membranen sind aus US 5,282,971 oder aus US 7,396,465 B2, negativ geladene Membranen aus US 7,132,049 B2 bekannt. Beispielsweise werden positiv geladene mikroporöse Membranen eingesetzt um Bakterien mechanisch zurückzuhalten und positiv geladene Stoffe passieren zu lassen, um eine ungerichtete, nicht quantifizierbare Adsorption durch das Membranmaterial zu vermeiden. Positiv und auch negativ geladene Membranen werden aber auch eingesetzt, um Proteine durch Adsorption zu binden und zu konzentrieren. Positiv geladene mikroporöse Membranen werden auch eingesetzt, um neben der Filtration Endotoxine und Viren über Adsorption zu binden wie beispielsweise in DE 1999981099947A1 dargestellt.

Alternativ ist auch bekannt, Polymembranen mit einem leitfähigen Material aus beispielweise Polypyrrol oder Polyanilin zu verwenden, um eine leitfähige Membran zu erhalten, welche zur Gas/Gas-, Gas/Flüssig- oder Flüssig/Flüssig-Separation verwendet werden können ("Elektrically conductive membranes; synthesis and applications", I.-H. Loh, R. A. Moody and J.C. Huang, Journal of Membrane Science, Vol. 50 (1990), 31-49).

Auch ist bekannt, Polymermembranen für den Einsatz in Extraktionsverfahren mit einem Sorptionsmittel, beispielsweise mit Polymeren von Ionischen Flüssigkeiten, mit Karbon-Nanoröhrchen oder Silizium- oder Kohlenstoffbasierenden Sorptionsmitteln, zu versehen ("Recent developments and future trends in solid phase microextraction techniques towards green analytical chemistry", A. Spieteltun et al., Journal of Chromatography A, Vol. 1321 (2013), 1-13).

Aus der CH 678403 ist eine mit Metall beschichtete Membran mit möglicherweise leicht porösen Durchgängen zwischen Makroporen auf einer und Mikroporen auf der metallischen Seite bekannt. Auch sind, beispielsweise aus der DE 101 64 214 A1 Metallmembranen mit tunnelartigen Durchgängen bekannt. Diese unterscheiden sich von im Sprachgebrauch der Anmeldung porösen Durchgängen, wie sie beispielsweise von porösen Polymermembranen bekannt sind, dadurch, dass sie außerhalb des eigentlichen Durchgangskanals innerhalb der Membran keine Kavitäten ausbilden. Porös ist somit nicht gleichzusetzen mit der Aussage, dass die Membran Poren, also Durchgänge, wie beispielsweise in der DE 101 64 214 A1 aufweist. Poröse Durchgänge weisen somit eine Oberfläche innerhalb der Membran auf, die die Oberfläche eines runden Tunnels mit gleicher Porengröße durch eine gleich dicke Membran deutlich übersteigt, mindestens um 50 %, insbesondere um ein Vielfaches, insbesondere mindestens um das 3-Fache.

Des Weiteren ist es aus der WO 1999/22843 A1 bekannt, eine Polymermembran mit Metall zu besputtern.

Auch ist es aus de US 4,857,080 bekannt, eine Membran mit einer Metallbeschichtung zu verschließen.

Darüber hinaus ist aus der WO 99/22843 A1 eine laminierte Polymermembran auf einer Stützstruktur bekannt auf welcher eine permeable Metallbeschichtung aufgetragen ist.

Eine weitere Form der Adsorption ist die Elektrosorption. Die Elektrosorption erfolgt durch Herstellung eines elektrisch geladenen Feldes an Oberflächen durch Anlegen einer positiven und negativen Spannung an zwei Elektroden. Eine Kombination aus Elektrosorption und ultraporöser Filtration ist in "Removal of arsenic and humic substances (HSs) by electro-ultrafiltration (EUF)" (Weng, Y.-H. et al. , Chem. Eng. R&D Vol.77, July 1999, Pages 461-468). Dabei wird durch Herstellung eines elektrischen Feldes durch eine externe Elektrode, die nahe an einer Ultrafiltrationsmembran positioniert ist, eine Adsorptionssteigerung von negativ geladenem Arsen (V) während der Filtration von Arsen belasteten Wassers durch eine Ultrafiltration von 30 % auf 90 % erreicht. Ein ähnlicher Einsatz von Elektrosorption in Kombination mit Membranen ist in US2013/0240361 A1 beschrieben. In einer Kombination von Stoffen mit stark adsorptiven Eigenschaften und deren Regeneration durch elektrische Ladung wird die Reinigung von Dialysewasser beschrieben. Das Verfahren wird in Kombination mit einem Dialysemembranfilter betrieben.

Eine Elektrosorptionsmembran ist in EP0872278A1 beschrieben. Hier wird eine Keramikmembran mit einer leitfähigen Schicht aus pyrolytischer Kohle versehen. Dabei werden die Poren mit pyrolytischer Kohle verschlossen und die keramische Oberfläche dann über hohe Temperatur durch Umwandlung der keramischen Oberfläche zu Carbid leitfähig gemacht. Mit dieser keramischen Membran wurden Salze adsorptiv über Elektrosorption an der Oberfläche gebunden. Eine mögliche Elektrosorption an der leitfähigen Oberfläche einer keramischen Membran erlaubt eine flexiblere Sorption von Stoffen, ist allerdings sehr aufwendig in der Herstellung. Dabei werden die Poren der Membran innerhalb des Verfahrens zur Herstellung der leitfähigen Oberfläche verschlossen, um in einem eine anschließenden Herstellungsschritt mittels sehr hoher Temperaturen die keramische Oberfläche mit einer leitfähigen Carbidschicht zu versehen.

Neben den Vorteilen der durch chemische Behandlung positiv oder negativ geladenen Membranen, nämlich der Kombination aus mechanischer Filtration und Adsorption, weisen diese auch einen Nachteil auf. Da die Ladung nicht variiert werden kann, können die Stoffe, die adsorptiv gebunden wurden, nach Beladung der Membran, nur durch eine Verschiebung der Ladung durch eine zu passierende Lösung, in der Regel durch pH-Wertveränderung, wieder von der Membran entfernt oder gewonnen werden. Insbesondere bei der Gewinnung von Wirkstoffen wie beispielsweise Proteinen durch Konzentration stellt dies einen zusätzlichen Aufwand dar. Endotoxine werden durch eine Verschiebung des pH Wertes in den basischen Bereich denaturiert. Diese pH-Wert Verschiebung wäre aber notwendig, um Endotoxine von einer positiv geladenen Membran zurückzugewinnen. Daher ist es nicht möglich, mittels dauerhaft geladener Membranen Endotoxine beispielsweise aus Blut zu gewinnen, um diese anschließend in eine farblose Flüssigkeit zu überführen und diese einer einfacheren Analytik zuzuführen.

Auch ist aus der EP 2 087 916 A1 eine Vorrichtung zum Entfernen von Toxinen aus Blut und anderen Flüssigkeiten bekannt, bei welcher mit einem Sorptionsmittel beschichtete Metallelektroden zum Einsatz kommen. Dabei wird nanostrukturiertes Sorptionsmaterial in eine Polymermatrix eingebracht, wobei die Poren der Polymermatrix derart gewählt sind, dass Toxine in diese eintreten können. Mit einer solchen Polymermatrix mit darin eingebrachtem Sorptionsmittel sind dann die Metallelektroden beschichtet. Aufgabe ist es, ein Verfahren zur zumindest temporären Separation und/oder zum Nachweis von geladenen biologisch aktiven Substanzen, insbesondere Endotoxinen aus Flüssigkeiten, insbesondere aus gefärbten Flüssigkeiten, zu etablieren.

Aufgabe ist es auch, ein Verfahren zum zumindest temporären Rückhalt von von geladenen biologisch aktiven Substanzen, insbesondere Endotoxinen zu etablieren, um beispielsweise eine Bestimmung des Gehaltes an Endotoxinen zu ermöglichen, die unabhängig von den anderen Stoffen der Ursprungsflüssigkeit erreicht werden kann. Ebenfalls Aufgabe ist ebenfalls es, eine entsprechende Vorrichtung anzugeben.

Gelöst werden die Aufgaben durch ein Verfahren nach Anspruch 1, sowie durch eine Elektrofiltrations- und/oder Elektrosorptionsvorrichtung nach Anspruch 8. Die abhängigen Ansprüche 2 bis 7 sowie 9 bis 12 geben vorteilhafte Weiterbildungen an.

Die Herstellung einer Polymermembran zur Verwendung im Verfahren und/oder der Vorrichtung mit flächiger und poröser Beschichtung aus Metall ist beispielsweise über Abscheidung mittels Magnetronsputtern möglich. Dies ermöglicht das großflächige Herstellen von dünnen Schichten mit einer homogenen Schichtdicke und auch komplexem Schichtaufbau. Grundlage der Magnetronabscheidung ist eine Plasmaentladung in Inertgasatmosphäre, z. B. Argon, welche durch ein statisches Magnetfeld verstärkt wird (A. Anders, Handbook of Plasma Immersion Ion Implantation and Deposition, Wiley-VHC, 2004). Die Ionen des Prozessgases werden Kathode beschleunigt und schlagen aus dieser beim Auftreffen Atome heraus. Folglich muss die Kathode (Target) aus dem Material bestehen, welches abgeschieden werden soll. Die aus dem Target ausgeschlagenen Atome kondensieren dann auf dem zu beschichteten Substrat und bilden eine kontinuierliche dünne Schicht. Diese Schichtdicke kann von wenigen Nanometern bis hin zu mehreren Mikrometern gesteuert erzeugt werden. Neben runden Magnetrons sind vor allem für die Beschichtung großer Flächen, z. B. in der Architekturglasbeschichtung, rechteckige Varianten mit mehreren Metern Länge weit verbreitet. Hier durch können Oberflächen von Membranen beschichtet werden.

Für die Herstellung der Polymermembranen mit flächiger und poröser Beschichtung aus Metall kann eine Polymermembran (beispielsweise Polysulfon, Polyethersulfon, Polypropylen oder Polyvinylidenfluorid) mittels des Magnetronsputterverfahrens mit einer dünnen Schicht Metall versehen werden. Dabei wird die Aufenthaltszeit der Membran im Prozess so niedrig gewählt, dass die Temperatur unter 200 °C, insbesondere unter 100°C, verbleibt und die Polymermembran in ihrer ursprünglich chemischen Struktur nicht beeinflusst wird. Als Beispiel wurde eine Polyethersulfonmembran mit mikroporöser Struktur mit einer 20 nm dünnen Schicht aus Aluminium mittels versehen. An dieser Membran wurden Porositätsuntersuchungen durchgeführt. Die folgende Tabelle zeigt die Ergebnisse der Porositätsmessung der Membran zum einen im Originalzustand zum anderen mit einer definiert dicken Schicht von 20 nm Aluminium.

**Tab.1.: Porengrößen einer mikroporösen Polyethersulfonmembran im Original und mit einer 20 nm dicken Aluminiumschicht.**

| | Polyethersulfonmembran | | |
|---|---|---|---|
| | 20 nm Beschichtung AI | Original | Differenz % |
| **Bubble point Porengröße (µm)** | 0,51 | 0,56 | 8,5 |
| **Mittlere Porengröße (µm)** | 0,41 | 0,43 | 6,1 |
| **Kleinste Porengröße (µm)** | 0,37 | 0,39 | 5,5 |

Es ist zu erkennen, dass die Porosität der Membran zu unter 10 % beeinflusst wird.

Dabei wird die Metallbeschichtung zumindest flächig auf einer ersten Seite der Polymermembran und/oder zumindest auf den von einer Seite zugänglichen Oberflächen aufgebracht, insbesondere bis die Schichtdicke der Beschichtung aus Metall der Polymermembran bezogen auf die initiale Bubble Point Pore und/oder die mittlere Porengröße der unbeschichteten Polymermembran zwischen 1 % und 45 % beträgt.

Insbesondere bei bevorzugten Beschichtung bis zu einer Dicke von bis zu 200nm ist es möglich, die Porengröße der Polymermembran, insbesondere Polysulfonmembran, insbesondere im Bereich von 0,1*µ*m bis 10*µ*m, kaum zu beeinflussen und somit weitgehend unverändert zu belassen.

Die Beschichtung ist insbesondere porös und insbesondere unmittelbar aufgebracht.

Als Metall für die Beschichtung kommen insbesondere Kupfer, Aluminium, Silber, Gold, Nickel, Platin und/oder Wolfram besteht oder Legierungen beinhaltend Kupfer, Aluminium, Silber, Gold, Nickel, Platin und/oder Wolfram infrage.

Als Polymermembran sind beispielsweise Membranen aus Polysulfon, Polypropylen, Polyethersulfon, Polyethermid, Polyacrylnitril, Polycarbonat, Polyethylenterephtalat, Polyvenylidenflourid (PVDF) und/oder Polytetraflourethylen oder solche Polysulfon, Polypropylen, Polyethersulfon, Polyethermid, Polyacrylnitril, Cellulose, Polycarbonat, Polyethylenterephtalat, Polyvenylidenflourid (PVDF) und/oder Polytetraflourethylen beinhaltend infrage.

Mit besonderem Vorteil ist Metall solange abgeschieden worden, bis die Schichtdicke der Beschichtung aus Metall der Polymermembran bezogen auf die initiale Bubble Point Pore und/oder die mittlere Porengröße der unbeschichteten Polymermembran zwischen 1 % und 45 % beträgt.

Bei diesen Werten lässt sich eine gute Leitfähigkeit mit gutem Durchsatz und hoher Porosität vereinen.

Bevorzugt ist Metall solange abgeschieden worden, bis die Porosität der Polymermembran mit Beschichtung aus Metall bezogen auf die initiale Bubble Point Pore und/oder die mittlere Porengröße gegenüber der unbeschichteten Polymermembran zwischen 1 % und 50% , insbesondere 1 und 20 % verringert ist. Auch diesen Werten lässt sich eine gute Leitfähigkeit mit gutem Durchsatz und hoher Porosität vereinen.

Bevorzugt ist Metall solange abgeschieden worden, bis die initiale Bubble Point Pore und/oder die mittlere Porengröße der Polymermembran mit Beschichtung aus Metall und/oder Aluminiumoxid 0,01 bis 10*µ*m beträgt. Dazu wird die Polymermembran mit einer initialen Bubble Point Pore und/oder mittleren Porengröße von mehr als 0,01 bis 10*µ*m gewählt.

Vorteilhafterweise ist die Polymermembran auf der ersten und einer der ersten Seite gegenüberliegenden zweiten Seite flächig mit Metall porös unmittelbar beschichtet. insbesondere sind die flächigen Beschichtungen, auch Metallisierungen, gegeneinander elektrisch isoliert.

Durch Auslassen der Beschichtung der porösen Durchgänge sowie der Kanten soweit, dass keine leitende Verbindung zwischen den beiden Seiten entsteht, kann eine Membran mit zwei elektrisch leitenden und gegeneinander isolierten Oberflächen schaffen.

Mit Vorteil ist Metall solange abgeschieden worden, bis die Dicke der Beschichtung aus Metall oder die mittlere Dicke der Beschichtung aus Metall mindestens 1nm, insbesondere mindestens 5 nm und maximal 50nm beträgt. Bei diesen Werten lässt sich bei mindestens 5 nm eine gute Leitfähigkeit mit gutem Durchsatz und hoher Porosität vereinen.

Mit Vorteil ist die die Porengröße der unbeschichteten Polymermembran zwischen 0,01 und 15*µ*m, insbesondere bis 10*µ*m und/oder größer gleich 0,1µm, gewählt. Hier lässt sich ein Verschließen der Poren mit Metall besonders gut verhindern.

Mit Vorteil ist Metall solange abgeschieden worden, bis die Dicke der Beschichtung aus Metall der Poren innerhalb der Membran oder die mittlere Dicke der Beschichtung aus Metall der Poren innerhalb der Membran mindestens 1 und maximal 50nm beträgt.

Auch durch den Einsatz einer metallbeschichtete Polymermembran aufweisend poröse Durchgänge, wobei die metallbeschichtete Polymermembran eine innenliegende Polymermembran mit porösen Durchgängen und eine Beschichtung aus Metall aufweist, dadurch gekennzeichnet, dass die Polymermembran vollständige von der Beschichtung aus Metall gekapselt ist und dass die Beschichtung aus Metall eine Dicke von 1 nm, insbesondere 5nm, bis 500 nm aufweist, wird die Aufgabe gelöst.

Dabei ist die Beschichtung insbesondere unmittelbar auf die Polymermembran aufgebracht. Insbesondere besteht die beschichtete Polymermembran ausschließlich aus der Polymermembran und der Metallbeschichtung.

Mit besonderem Vorteil, weist die Polymermembran mit Beschichtung aus Metall somit bezogen auf die initiale Bubble Point Pore und/oder die mittlere Porengröße gegenüber der unbeschichteten Polymermembran eine zwischen 1 % und 50 %, insbesondere 1 % und 20 %, verringerte eine Porosität auf.

Die Membran kann beispielsweise auch gefaltet werden und/oder gefaltet verwendet werden, wie dies bei herkömmlichen Membranen bekannt ist. Insbesondere wird mindestens eine isolierende Falthilfe, insbesondere an jeder Seite der Membran mindestens eine, verwendet und/oder beinhaltet. Diese erlauben einen Flüssigkeitsdurchtritt und sorgen insbesondere für eine Isolierung der einzelnen Falten voneinander. Insbesondere wird die mindestens eine Falthilfe vor der Faltung auf einer oder beiden Seiten der Membran angeordnet und zusammen mit der Membran gefaltet. Die Falthilfen müssen nicht aus vollständig isolierendem Material gebildet sein, so kann beispielsweise ein Polymervlies verwendet werden, der insbesondere einseitig oder beidseitig elektrisch leitend beschichtet ist, wobei der Vlies selbst aber für eine Isolation sorgt.

Für die Lösung der Aufgabe zur zumindest temporären Separation und/oder zum Nachweis von geladenen biologisch aktiven Substanzen wird verfahrensgemäß
a. eine Polymermembran mit flächiger und poröser Beschichtung aus Metall, insbesondere wie vorstehend beschrieben, zumindest auf einer ersten Seite, insbesondere zwei Seiten, der Polymermembran bereitgestellt;
b. eine Gegenelektrode bereitgestellt;
c. eine Spannung zwischen der Beschichtung aus Metall der Polymermembran und der Gegenelektrode angelegt;
d. die Polymermembran und insbesondere die Gegenelektrode mit der Flüssigkeit in Kontakt gebracht, wobei das in Kontakt bringen insbesondere der Art erfolgt, dass die Flüssigkeit mindestens eine Verbindung zwischen der Polymermembran und der Gegenelektrode erzeugt.

Durch ein solches Verfahren lassen sich aus Flüssigkeiten, beispielsweise aus Blut, geladene Substanzen, insbesondere biologisch aktive geladene Substanzen, aber auch andere geladene Substanzen, zumindest temporär durch Bindung an die Polymermembran mit Metallbeschichtung adsorbieren und/oder zurückhalten, dadurch insbesondere separieren. Dabei ist eine deutlich angepasstere und flexiblere Verfahrensführung möglich, als dies bei bekannten (ionisch) geladenen Membranen möglich ist. Auch kann durch eine Umpolung der Spannung, die nicht dieselbe Höhe der Spannung mit umgekehrten Vorzeichen voraussetzt, sondern auch einen geringeren oder höheren Betrag aufweisen kann, und/oder Verringern der Spannung eine Ablösung, beispielsweise zur Rückgewinnung, beispielsweise in eine andere Flüssigkeit, erleichtert werden, insbesondere ohne dass es dazu einer pH-Wert-Veränderung bedarf.

Der Betrag der Spannung beträgt vorteilhafter Weise maximal 1,5 V. Insbesondere beträgt der Betrag der Spannung auch nach einem Umpolen maximal 1,5 V. Die Spannung oder die zu Ihrer Erzeugung benötigte Energie kann beispielsweise kapazitiv, induktiv und/oder durch Kabel übertragen werden. Insbesondere kann die Spannung oder die zu Ihrer Erzeugung benötigte Energie in ein Gehäuse, das Polymermembran und Gegenelektrode umschließet, insbesondere induktiv, übertragen werden. Die Spannung oder die zu Ihrer Erzeugung benötigte Energie kann beispielsweise induktiv in das Gehäuse eingekoppelt werden und innerhalb des Gehäuses über Kabel auf die Polymermembran und die Gegenelektrode gebracht werden.

Unter geladenen biologisch aktiven Substanzen ist eine Vielzahl von Substanzen zu verstehen. Dabei kann, beispielsweise durch gezielte Wahl der Spannung und/oder der Membranoberfläche eine mehr oder weniger spezifische Rückhaltung, Separation bzw. ein mehr oder weniger spezifischer Nachweis für einzelne oder zahlreiche Substanzen ermöglicht werden. Dabei ist ein Rückhalt und/oder eine Adsorbtion an/durch der/die Membran von stärker geladenen Teilchen bereits bei geringeren Spannungen möglich als weniger geladener Teilchen. Dadurch wird eine gewisse Selektivität durch Wahl der Spannung ermöglicht. Es ist dabei nicht unbedingt notwendig nur eine einzelne Substanz zu separieren und/oder nachzuweisen. Als biologisch aktive Substanzen kommen zum Beispiel in Frage Viren, Bakterien, Endotoxine, Proteine, Aminosäuren, Zwitterionen, Substanzen mit isoelektrischem Punkt, Exosome und/oder Vesikel. Um als geladen angesehen zu werden, müssen sie nicht in jeder Umgebung eine Ladung aufweisen. Es reicht aus, dass sie in einem Zustand, in dem sie in Kontakt mit der Membran gebracht werden oder werden können, eine Ladung aufweisen, insbesondere liegen sie in der Flüssigkeit zumindest teilweise in einem geladenen Zustand vor. So wird bei der Separation und/oder dem Nachweis, insbesondere von Proteinen, insbesondere Viren, insbesondere in einer Lösung mit einem pH-Wert gearbeitet, bei dem die zurück zuhaltenden und/oder zu adsorbierenden Substanzen eine möglichst große Ladung aufweisen, insbesondere relativ zu Substanzen, die nicht zurückzuhalten oder adsorbieren sind.

In der Regel werden Polymermembran mit Metallbeschichtung und insbesondere auch die Gegenelektrode umfangreich in Kontakt mit der Flüssigkeit gebracht, insbesondere großflächig benetzt. Ausreichend ist aber schon ein kleinflächiger Kontakt oder die kleinflächige Verbindung, beispielsweise durch einen Tropfen zwischen Gegenelektrode und Polymermembran mit Metallbeschichtung. Auch kann das Inkontaktbringen durch Füllen einer oder einer Vielzahl von Poren einer zweiseitig metallisch beschichteten Polymermembran, deren eine Seite als Gegenelektrode eingesetzt wird, erreicht werden.

Mit besonderem Vorteil wird die Gegenelektrode entweder durch eine weitere flächige, poröse Beschichtung aus Metall auf einer zweiten, der ersten Seite gegenüberliegenden Seite gebildet, wobei die flächigen Beschichtungen aus Metall gegeneinander durch die Polymermembran isoliert sind, oder durch eine unter Zwischenlage eines isolierenden und permeablen Spacers und/oder unter Beabstandung angeordnete permeable Elektrode, insbesondere gebildet durch ein metallisches Netz und/oder eine Stabelektrode.

Vorteilhafterweise wird die Porosität der Polymermembran mit Beschichtung aus Metall mit bezogen auf die initiale Bubble Point Pore und/oder die mittlere Porengröße gegenüber der unbeschichteten Polymermembran zwischen 1 % und 50% , insbesondere 1 und 20 % verringert gewählt. Dabei ist eine zuverlässige Leitfähigkeit bei gleichzeitig großer Porosität gegeben.

Mit Vorteil wir die Polymermembran derart gewählt, dass die Dicke der Beschichtung aus Metall 1nm, insbesondere 5 bis 50nm beträgt und/oder die Porengröße der unbeschichteten Polymermembran insbesondere größer als 0,01 µm und insbesondere kleiner als 15 *µ*m, ist. Dabei ist eine zuverlässige Leitfähigkeit bei gleichzeitig großer Porosität gegeben.

Mit besonderem Vorteil wird eine Referenzelektrode zu Messzwecken bereitgestellt und das Potenzial an der Referenzelektrode gemessen.

Vorteilhafterweise wird neben Polymermembran mit Metallbeschichtung, die erfindungsgemäß als Elektrode verwendet wird und Gegenelektrode sowie gegebenenfalls Referenzelektrode mindestens eine weitere Elektrode vorgesehen, insbesondere mindestens eine weitere Polymermembran mit Metallbeschichtung oder eine weitere Seite der Polymermembran mit Metallbeschichtung, insbesondere wie oben stehend erläutert als weitere Elektrode vorgesehen. Diese zusätzliche Elektrode wird insbesondere ebenfalls im gemeinsamen Gehäuse und elektrisch von der Polymermembran mit Metallbeschichtung und der Gegenelektrode isoliert angeordnet. Das gemeinsame Gehäuse kann auch ein äußeres Gehäuse sein, dass ein inneres Gehäuse, in dem Polymermembran und Gegenelektrode angeordnet sind, umschließt.

Insbesondere wird an die mindestens eine weitere Elektrode eine Spannung angelegt, die so gewählt ist, dass das Potenzial der Gegenelektrode zwischen dem Potenzial der Polymermembran mit Metallbeschichtung und der mindestens einen weiteren Elektrode zu liegen kommt. Insbesondere wird die Gegenelektrode im Gehäuse zwischen der Polymermembran mit Metallbeschichtung und der mindestens einen weiteren Elektrode angeordnet.

In diesem Fall kann es auch sinnvoll sein, mehrere Referenzelektroden einzusetzen und jeweils zwischen den Elektroden und/oder Gegenelektrode anzuordnen.

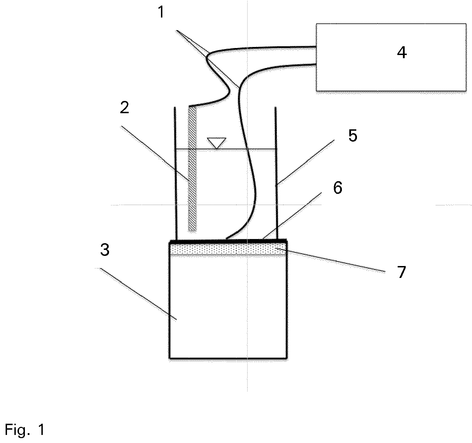

Es wurden Versuche zur Elektrosorption an einer Polyethersulfonmembran mit einer Porengröße von 0,2*µ*m in einer Anordnung wie in Figur 1 durchgeführt. Dazu wurde eine Laborfiltrationsmembran mit einem Durchmesser von d = 47 mm mit einer 15-nm-Schicht Aluminium mittels Magnetronsputtern versehen. An die Aluminiumoberfläche wurde ein Kupferkabel geklebt und mit einem isolierenden Lack versehen. Das verbleibende Kabel war ca. 30 cm lang und isoliert. Die Membran wurde in eine handelsübliche Unterdruckfiltrationseinheit eingebracht. Das Vorlagegefäß wurde mit Reinwasser gefüllt und darin eine Gegenelektrode aus Platin eingebracht.

In das Reinwasser im Vorlagegefäß wurden Endotoxine eingebracht, sodass sich im Reinwasser im Vorlagegefäß eine Endotoxinkonzentration von 1.000 IE (Internationale Einheiten Endotoxin) einstellte. Die Filtration erfolgte ohne Druck. Es erfolgte eine Filtration der Membran im Originalzustand ohne Beschichtung und eine Filtration mit einer Membran einer Beschichtung von 15 nm. An die beschichtete Membran wurde eine Spannung von + 500 mV angelegt. Die Ergebnisse sind in der folgenden Tabelle dargestellt.

| | Konzentration Endotoxin in EU/ml | | ml |
|---|---|---|---|
| | Vorlage | Auffanggefäß | Probenvolumen |
| Filter ohne Beschichtung | 1000 | 952,5 | 100 |
| Filter mit Beschichtung bei + 500 mV | 1000 | 0,3 | 50 |

Es ist deutlich zu erkennen, dass über die geladene Aluminiumbeschichtung Endotoxine fast vollständig zurückgehalten, insbesondere adsorbiert werden, sodass die Konzentration im Auffanggefäß nahe null ist. Die Polymermembran im Originalzustand ohne Metallbeschichtung, aber auch auch die metallbeschichtete Polymermembran ohne Spannung adsorbiert wenig.

Die adsorbierten Endotoxine können durch Umpolen der Spannung und Spülen der Membran wieder gelöst und von der Membran entfernt werden.

Ähnlich wie bei dem oben beschriebenen Versuch zum Rückhalt von Endotoxinen kann auch ein Rückhalt von Viren erreicht werden. Es ist bekannt, dass Viren oberhalb ihres isoelektrischen Punktes eine negative Ladung aufweisen und an Oberflächen mit einer positiven Ladung adsorbtiv gebunden werden können (Adsorption of Viruses to chargedmodified Silica, Zerda et al. Applied and Environmental Microbiology, Jan 1985, p. 91-95) . Mit dem gleichen Versuchsaufbau wie oben betreffend den Rückhalt von Bakterien beschrieben wurden Versuche zum Rückhalt von Viren durchgeführt. Dabei wurden Bakteriophagen MS2 mit einer Größe von 25 nm (Durchmesser) verwendet. Der isoelektrische Punkt dieser Bakteriophagen liegt bei pH 3,9. Es wurden 15 ml einer wässrigen Lösung 10⁵ PFU/ml (plaque forming units/ml) über die Membran bei einem pH-Wert der Lösung von 7 filtriert. Es wurden Membranen aus Polyethersulfon 0,2*µ*m ohne Beschichtung und mit einer Beschichtung aus Titan (20 nm) sowie einer Beschichtung aus Gold (20 nm) untersucht. In der folgenden Tabelle sind die Ergebnisse der Versuche dargestellt:

| Beschichtung | Spannung in Volt | Rückhalt in Log 10 |
|---|---|---|
| ohne | 0,0 | 0,1 |
| Titan | 0,0 | 0,05 |
| Titan | 1,0 | 1,4 |
| Gold | 0,0 | < 0,01 |
| Gold | 1,0 | 2,4 |

Betrachtet man die Ergebnisse der Versuche zum Rückhalt, insbesondere zur Adsorption, ohne Beschichtung und ohne Spannung, wird an der Membran ohne Beschichtung ein geringer Rückhalt an Viren erzielt. Polymermembranen besitzen ohne Beschichtung ein Zeta-Potential (Oberflächenspannung). Titan und Gold besitzen geringeres ein Zeta-Potential (nahe Null). So ist es nachvollziehbar, dass ohne Spannung an der Membran ohne Beschichtung im Vergleich zu den beschichteten Membranen am meisten Viren adsorbiert werden, da eine Beschichtung der Membran aus Titan oder Gold das Zeta-Potential und damit die Ladung der Membran reduziert.

Betrachtet man die Ergebnisse der Versuche zur Adsorption unter einer Spannung von 1,0 Volt, so wird mit der Beschichtung aus Titan ein Rückhalt von Viren in einer Größenordnung von 1,4 Log₁₀ (also ein Rückhalt von > 95%) und bei einer Beschichtung von Gold in einer Größenordnung von 2,4 Log₁₀ ( also ein Rückhalt > 99%) erreicht.

Es konnte gezeigt werden, dass sich mittels einer mit einer Metallschicht versehenen Membran und einer aufgebrachten Spannung von 0,5 Volt bzw. 1,0 Volt eine signifikante Verbesserung der Rückhaltung, insbesondere Adsorption, von Endotoxinen als auch von Viren gegenüber einer nicht geladenen Membran erzielen lässt.

Zudem konnten nach Umschalten der Spannung bei den Versuchen zum Rückhalt der Endotoxine von + 500mV zu -500mV zumindest 50% der adsorptiv gebundenen Endotoxine durch Spülen der Membran mit Wasser wieder in das Wasser zurück gewonnen werden können. Damit konnte gezeigt werden, dass zumindest ein Teil der Endotoxine durch Umkehrung der Spannung wieder desorbiert werden.

Gelöst wird die Aufgabe auch durch ein Verfahren zur Bestimmung der Belegung der Bindungsplätze der Polymermembran mit flächiger und poröser Beschichtung aus Metall und/oder zur Bestimmung mindestens einer zumindest relativen Konzentration in der Flüssigkeit, wobei dieses Verfahren auf dem Verfahren zur zumindest temporären Separation und/oder zum Nachweis von geladenen biologisch aktiven Substanzen in einer Flüssigkeit aufsetzt von allen vorteilhaften Ausbildungen Gebrauch machen kann und gekennzeichnet ist dadurch, dass der durch die angelegte Spannung bewirkte Stromfluss erfasst und/oder ausgewertet wird, insbesondere hinsichtlich der Unterschreitung einer Grenze und/oder der Überschreitung einer positiven und/oder negativen Änderungsrate und/oder seines zeitlichen Verlaufs ausgewertet wird und insbesondere bei Unterschreiten oder Überschreiten eine Alarmierung ausgelöst wird. Dadurch lassen sich beispielsweise Konzentrationsgrenzen oder Änderungsraten von Konzentrationen überwachen. Eine solche Überwachung kann sehr engmaschig und sogar in Echtzeit erfolgen. So kann beispielsweise die Endotoxinkonzentration im Blut überwacht werden. Der Stromfluss ist abhängig von der Belegung der Bindungsstellen auf der Membran. Sind weniger Bindungsstellen verfügbar fällt der Stromfluss ab. Dabei muss die Konzentration nicht als absoluter Wert bestimmt werden, es reicht auch aus, Unter- oder Überschreiten von Referenzwerten zu erkennen, die Referenzwerte können dabei auch in Form von Stromflüssen gegeben sein.

So kann beispielsweise eine Alarmierung bei Überschreiten bestimmter Konzentrationsgrenzen und/oder Änderungsraten, insbesondere gemessen als Änderungsrate des Stromflusses, erfolgen, beispielswiese akustisch, optisch und oder elektrisch.

Gegenständlich wird die Aufgabe gelöst durch Elektrosorptions- und/oder Elektrofiltrationsvorrichtung beinhaltend eine Gegenelektrode und eine Polymermembran mit flächiger und poröser Beschichtung aus Metall auf zumindest einer Seite der Polymermembran, insbesondere wie oben beschrieben, und eine Kontaktierung der Beschichtung aus Metall zur Anlage einer Spannung gegenüber der Gegenelektrode. Dabei gilt oben Ausgeführtes, insbesondere in Bezug auf Elektrode, Membran, Beschichtung, Gegenelektrode, Referenzelektrode und/oder Anordnung auch für die Vorrichtung.

Dabei sind die Polymermembran und insbesondere auch die Gegenelektrode in einem Gehäuse angeordnet, das insbesondere als Spritzenvorsatz ausgebildet ist und/oder ein geringes Hold-Up Volumen, insbesondere von maximal 10 ml und/oder maximal 20 mm^3/mm^2-Beschichtung aus Metall auf der Polymermembran aufweist, insbesondere maximal 2 mm^3/mm^2-Beschichtung aus Metall auf der Polymermembran, und/oder sind die Polymermembran und die Gegenelektrode eingerichtet, mit einer Spannungsquelle verbunden zu werden oder sind mit einer solchen verbunden, die eingerichtet ist eine Spannung zwischen Polymermembran und Gegenelektrode auszubilden und wobei insbesondere die Spannungsquelle mit der Polymermembran und der Gegenelektrode in einem gemeinsamen Gehäuse angeordnet ist und/oder ist eine Strommessvorrichtung vorgesehen ist, die den zwischen Polymermembran und Gegenelektrode fließenden Strom und/oder dessen Änderungsrate misst und/oder mit einem Grenzwert vergleicht und/oder ist die Spannungsquelle zum Umpolen der Spannung eingerichtet.

Zum Verbinden mit einer Spanungsquelle und/oder zur Kontaktierung der Beschichtung aus Metall kann die Metallbeschichtung der Membran beispielsweise direkt mit einem elektrischen Leiter, z. B. einem Kabel, verbunden und/oder in Kontakt gebracht werden, beispielsweise durch Löten oder Schweißen. Sie kann aber zusätzlich oder alternativ beispielsweise mit anderen elektrisch leitenden Bauteilen, beispielsweise mit einem Käfig, in den die Membran eingesetzt wird, und/oder mit mindestens einer leitfähig beschichteten Falthilfe, in Kontakt gebracht werden und mittels dieser und gegebenenfalls weiteren Bauteilen und/oder Kabeln mit der Spannungsquelle verbunden sein oder werden und/oder dadurch Kontaktiert sein.

Auch ist es Möglich, in die Verbindung zur Spannungsquelle eine induktive und/oder kapazitive Kopplung einzuarbeiten, sodass beispielsweise auch ein Verbinden mit der Spannungsquelle durch ein geschlossenes Gehäuse hindurch ohne entsprechende Kabeldurchführungen möglich ist.

Das gemeinsame Gehäuse kann auch ein äußeres Gehäuse sein, dass ein inneres Gehäuse, in dem Polymermembran und Gegenelektrode angeordnet sind, umschließt.

Dabei ist im Gehäuse insbesondere ein Aufenthaltsvolumen für Flüssigkeit vorgesehen, in dem Flüssigkeit verweilen oder durch das Flüssigkeit hindurch bewegt werden kann. Innerhalb dieses Volumens ist dann die flächige und poröse Beschichtung aus Metall der Polymermembran und insbesondere auch die Gegenelektrode angeordnet. Dieses Aufenthaltsvolumen ist insbesondere mit zumindest einem, insbesondere zwei Anschlüssen für Schläuche und/oder Spritzen, insbesondere ausgebildet als Luer-Lock Anschluss, in flüssigkeitsdurchlässiger Verbindung angeordnet. Insbesondere stellt dieses Aufenthaltsvolumen zusammen mit dem Volumen des mindestens einen, insbesondere der zwei, Anschlüsse und der flüssigkeitsdurchlässigen Verbindung das Hold-Up Volumen dar.

Die Vorrichtung kann, insbesondere im gemeinsamen Gehäuse, auch eine Vorrichtung zur Erzeugung einer Spannung, beispielsweise eine Batterie, beinhalten, die insbesondere so angeordnet und/oder kontaktiert ist, dass sie ein Potenzial zwischen Metallbeschichtung der Polymermembran und Gegenelektrode erzeugen kann.

Die Vorrichtung ist als Spritzenvorsatz, ausgebildet. Gegenelektrode und Polymermembran mit flächiger und poröser Beschichtung aus Metall sind insbesondere gegeneinander elektrisch isoliert.

Elektrosorptions- und/oder Elektrofiltrationsvorrichtung weist dazu insbesondere ein Gefäß und/oder Gehäuse auf, zur Anordnung und/oder Durchleitung von Flüssigkeit, indem die Polymermembran und die Gegenelektrode elektrisch voneinander isoliert angeordnet sind.

Die Elektrosorptions- und/oder Elektrofiltrationsvorrichtung kann eine oder mehrere Referenzelektroden beinhalten.

Sie kann vorteilhafterweise auch mindestens eine weitere Elektrode wie oben in Bezug auf das Elektrosorptions- und/oder Elektrofiltrationsverfahren beschrieben enthalten. Auch die weiteren in Bezug zu diesem Verfahren beschriebenen gegenständlichen Merkmal lassen sich vorteilhaft in der Elektrosorptions- und/oder Elektrofiltrationsvorrichtung umsetzten.

Bei der Polymermembran mit Metallbeschichtung handelt es sich vorteilhafterweise um eine metallbeschichtete Polymermembran wie oben beschrieben. Diese eignen sich besonders gut, insbesondere, wenn auch die porösen Durchgänge mit Metall beschichtet sind. Da die elektrisch aktive Oberfläche dann deutlich größer ausfällt. Es können aber auch andere metallbeschichtete Polymermembranen verwendet werden.

Mit besonderem Vorteil handelt es sich bei der Gegenelektrode entweder um eine weitere flächige, poröse Beschichtung aus Metall auf einer zweiten, der ersten Seite gegenüberliegenden Seite oder um eine unter Zwischenlage eines isolierenden und permeablen Spacers angeordnete permeable Elektrode, insbesondere gebildet durch ein metallisches Netz.

Mit Vorteil ist die Vorrichtung zur Durchführung des Verfahren zur zumindest temporären Separation und/oder zum Nachweis von geladenen biologisch aktiven Substanzen, insbesondere mit einigen oder allen vorteilhaften Ausprägungen, eingerichtet. Insbesondere ist sie auch eingerichtet zur Durchführung des Verfahrens zur Bestimmung der Belegung der Bindungsplätze der Polymermembran mit flächiger und poröser Beschichtung aus Metall und/oder zur Bestimmung mindestens einer Konzentration in der Flüssigkeit. Das Verfahren wird insbesondere mit einer erfindungsgemäßen Vorrichtung durchgeführt.

Weitere vorteilhafte Ausgestaltungen sollen im folgenden rein exemplarisch anhand der folgenden schematischen Zeichnungen erläutert werden. Dabei zeigen:
- Figur 1 :: eine Elektrofiltrationsvorrichtung
- Figur 2:: eine erfindungsgemäße Elektrofiltrationsvorrichtung als Spritzenvorsatzfilter
- Figur 3:: eine erfindungsgemäße Elektrofiltrationsvorrichtung mit gefalteter Membran ausgebildet als Kartusche in einem Gehäuse.

Figur 1 zeigt eine Elektrofiltrationsvorrichtung. Mit dieser kann ein Elektrofiltrationsverfahren durchgeführt werden.

Eine Flüssigkeit wird in das Vorlagengefäß (5) eingefüllt und durch die Membran (6), gebildet durch eine metallbeschichtete Polymermembran unter Anlage einer Spannung, angelegt durch einen Potentiostat (4), zwischen der als Elektrode ausgeblideten Membran (6), und Gegenelektrode (2) in das Auffanggefäß (3) filtriert. Die Fritte (7) dient zur Stabilisierung der Membran.

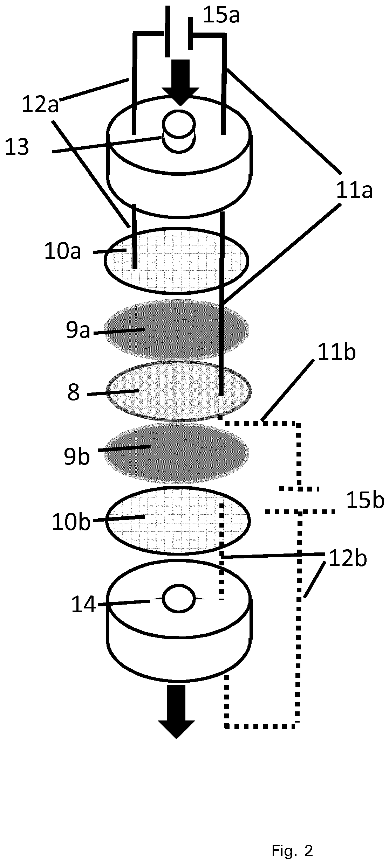

Figur 2 zeigt eine erfindungsgemäße Elektrofiltrationsvorrichtung ausgebildet als Spritzenvorsatzfilter. Gezeigt ist eine Rundmembran (8) aus Polymermaterial, einseitig oder beidseitig metallisiert. Die Metallisierung kann dabei einseitig, upstream seitig der Membran (in der Figur oben) oder downstream seitig der Membran (in der Figur unten) oder beidseitig aufgebracht sein. Bei beiderseitigem Aufbringen sind die metallisiert den Seiten insbesondere gegeneinander isoliert.

Grundsätzlich zeigt die Figur 2 zwei mögliche Ausgestaltungen in einer Figur. Es entweder alle mit dem Zusatz b bezeichneten Teile entfallen oder alle mit Zusatz a bezeichneten Teile .

Der Filter weist insbesondere auch mindestens eine Gegenelektrode (10a oder 10b, 12a oder 12b) auf. Diese kann beispielsweise als Metallgitter ausgeführt sein.

Beinhaltet können sein elektrisch isolierende, jedoch permeable Trennfolien (9a oder 9b), die den Fluss einer Flüssigkeit in die durch die Pfeile gekennzeichnete Richtung erlauben, aber für eine elektrische Isolation zwischen Rundmembran (8) und Gegenelektrode (10a oder 10b) Sorge tragen. Es ist jedoch auch eine Ausführung ohne derartige Trennlinie möglich, wenn durch andere konstruktive Maßnahmen eine entsprechende Isolation sichergestellt wird.

Der Spritzenvorsatzfilter weist einen Filtereinlauf (13) auf. Er weist auch einen Filterauslauf (14). Diese können Durchführungen für die Kontaktierung beinhalten. Diese können durch Kabel aber auch induktiv, kapazitiv, durch Stecker und/oder Ähnliches realisiert sein.

Beinhaltet sind auch elektrische Leiter (12a oder 12b und 11a oder 11b). Die Leiter (12a oder 12b) können auch selbst als Gegenelektrode dienen und somit die Gegenelektroden (10a oder 10b) ersetzen.

Filtereinlauf und Filterauslauf sind insbesondere Teil eines Gehäuses zur hermetischen Versiegelung des gesamten Filters, sodass ein Flüssigkeitsverlust nur zwischen Filtereinlauf und von Filterauslauf möglich ist und zwar nur unter Passierung der im Flüssigkeitslauf angeordneten Elemente, wie Rundmembran, Trendfolie und Gegenelektrode, sofern als permeable oder Gitter ausgebildet.

Der Spritzenvorsatzfilter ist dabei so ausgebildet, dass er es ermöglicht, ein Potenzial zwischen Metallisierung der Rundmembran und Gegenelektrode anzulegen. Dazu weist er insbesondere entsprechende Leiter, Durchführungen und/oder Kontaktierung und/oder Übertragungsvorrichtungen (insbesondere induktiv und/oder kapazitiv) auf. Das Anlegen von Spannung kann dabei beispielsweise über eine Spannungsquelle (15a oder 15b) und elektrische Leiter 12a oder 12b und 11a oder 11b) realisiert werden.

Mithilfe eines solchen Spritzenvorsatzfilters mit einer Spannungsquelle (15a oder 15b) kann beispielsweise unter einer ersten Polarisierung der Spannungsquelle bei Durchführung von Flüssigkeit, insbesondere Blut, durch den Spritzenvorsatzfilter eine Adsorption von in der Flüssigkeit beinhalteter Stoffe, beispielsweise Endotoxine, an der Rundmembran (8) erfolgen.

Später kann, insbesondere unter umgekehrter Polarisierung oder ohne Spannung und Durchführen einer weiteren Flüssigkeit, insbesondere Entgegen der durch die Pfeile dargestellten Fließrichtung, beispielsweise Wasser, eine Abgabe der Stoffe erfolgen.

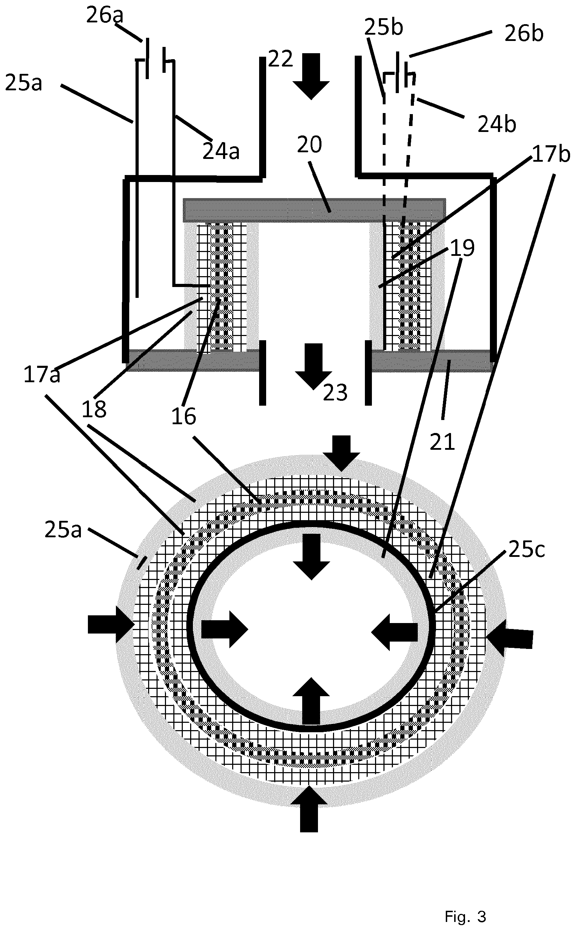

Figur 3 zeigt eine erfindungsgemäße Kartusche in einem Gehäuse mit gefalteter Membran (16). Dem Stand der Technik nach werden solche Faltfilterkartuschen folgenderma-ßen hergestellt:
1. Die Membran (16) wird zwischen zwei Faltenhilfen (17a und 17b), insbesondere aus einem/r Polymerfließ und/oder -folie, positioniert und gefaltet.
2. Die gefertigte gefaltete Membran wird in einen runden Käfig (Cage) gedrückt (18) damit sich diese nicht wieder entfaltet und mit einem Kern (Core) versehen. Käfig und Kern sind insbesondere aus Kunststoff und insbesondere so ausgestaltet, dass Flüssigkeit hindurch treten kann, insbesondere mit rechteckigen oder runden Löchern versehen .
3. Die Membran mit Falthilfe und Käfig und Kern werden mit dem oberen Verschluss einer geschlossenen Kunststoffkappe verschweißt und anschließend mit dem unteren Verschluss (Platte mit Öffnung) verschweißt.

So wurde auch in diesem Ausführungsbeispiel verfahren und kann generell mit der erfindungsgemäß beinhalteten und/oder verwendeten Membran verfahren werden.

Gezeigt ist in Figur 3 eine gefaltete Membran (16) aus Polymermaterial, einseitig oder beidseitig metallisiert. Die Metallisierung kann dabei einseitig, upstream seitig der Membran (in der Figur außen) oder downstream seitig der Membran (in der Figur innen) oder beidseitig aufgebracht sein. Bei beiderseitigem Aufbringen sind die metallisiert den Seiten insbesondere gegeneinander durch die Membran selbst isoliert. Die Faltung der Membran erfolgt insbesondere mittels mit der Membran gefalteter Falthilfen, die insbesondere aus einem Polymerfließ bestehen (17a,b). Das Polymerfließ kann sowohl als leifähiges (mit beidseiteiger Metallbeschichtung) oder aber als Spannungs-isolierendes Fließ ausgeführt sein.

Grundsätzlich zeigt die Figur 3 zwei mögliche Ausgestaltungen in einer Figur. Es entfallen entweder alle mit dem Zusatz b bezeichneten Teile oder alle mit Zusatz a bezeichneten Teile. Mit Vorteil wird in der Variante, in der die mit dem Zusatz a bezeichneten Teile enthalten sind, die Membran über eine elektrische Leitung als Elektrode direkt kontaktiert oder in der Variante, in der die mit dem Zusatz b bezeichneten Teile enthalten sind, die Membran als Elektrode über eine elektrisch leitende Falthilfe (17b) und über einen elektrisch leitenden Kern (Core), der die gefaltete Membran hält, kontaktiert.

Der Filter weist insbesondere auch mindestens eine Gegenelektrode (25a oder 25c) auf. Diese kann beispielsweise als Metallgitter und/oder Stabelektrode ausgeführt sein.

Der als Kartusche mit gefalteter Membran ausgeführter Filter weist einen Filtereinlauf (22) auf. Er weist auch einen Filterauslauf (23) auf. Diese können Durchführungen für die Kontaktierung beinhalten. Diese können durch Kabel aber auch induktiv, kapazitiv, durch Stecker und/oder Ähnliches realisiert sein.

Beinhaltet sind auch elektrische Leiter (24 a und 25a oder 24b und 25b). Die Leiter (25a oder 25b) können als Gegenelektrode. dienen und somit die Gegenelektroden ersetzen.

Filtereinlauf und Filterauslauf sind insbesondere Teil eines Gehäuses zur hermetischen Versiegelung des gesamten Filters, sodass ein Flüssigkeitsverlust nur zwischen Filtereinlauf und von Filterauslauf möglich ist und zwar nur unter Passierung der im Flüssigkeitslauf angeordneten Elemente, wie Membran und Gegenelektrode, sofern als permeable oder Gitter ausgebildet.

Die Kartusche mit gefalteter Membran ist dabei so ausgebildet, dass er es ermöglicht, ein Potenzial zwischen Metallisierung der Membran und Gegenelektrode anzulegen. Dazu weist er insbesondere entsprechende Leiter, Durchführungen und/oder Kontaktierung und/oder Übertragungsvorrichtungen (insbesondere induktiv und/oder kapazitiv) auf. Das Anlegen von Spannung kann dabei beispielsweise über eine Spannungsquelle (26a oder 26b) und elektrische Leiter 25a oder 25b und 24a oder 24b) realisiert werden.

Mithilfe eines solchen Kartusche mit gefalteter Membran mit einer Spannungsquelle (26a oder 26b) kann beispielsweise unter einer ersten Polarisierung der Spannungsquelle bei Durchführung von Flüssigkeit durch die Kartusche mit gefalteter Membran eine Adsorption von in der Flüssigkeit beinhalteten Substanzen, an der gefalteten Membran (8) erfolgen.

Später kann, insbesondere unter umgekehrter Polarisierung oder ohne Spannung und insbesondere Durchführen einer weiteren Flüssigkeit, insbesondere in zur durch die Pfeile gekennzeichneten Fließrichtung umgekehrten Fließrichtung, beispielsweise Wasser, eine Desorption der zuvor elektrosorptiv an der gefalteten Membran des Filters gebundenen Substanzen erfolgen.

### Bezugszeichenliste

- 1: Kabel
- 2: Gegenelektrode
- 3: Auffanggefäß
- 4: Potentiostat
- 5: Vorlagegefäß
- 6: Membran
- 7: Fritte
- 8: Rundmembran (Polymer) mit einseitiger (upstream oder downstream seitigen) oder beidseitiger Metallisierung
- 9: a und b Elektrisch isolierende, permeable Trennfolie
- 10: a und b Gegenelektrode upstream (a) bzw. downstram (b) der schaltbaren Rundmembran 1 in der Form eines permeablen Metallgitters
- 11: a Metalldraht zur Kontaktierung der upstreamseitigen Metallisierung der Rundmembran 8
b Metalldraht zur Kontaktierung der downstreamseitigen Metallisierung der Rundmembran 8
- 12: a und b elektrischer Leiter zur Gegenelektrode/Metallgitter 10a bzw. 10b
- 13: Filtereinlauf mit Durchführung(en) zur elektrischen Kontaktierung von Elektrode/Membran und Gegenelektrode
- 14: Filterauslauf optional mit Durchführung zur elektrischen Kontaktierung der Gegenelektrode/Metallgitter
- 15: a Spannungsquelle zur Beaufschlagung von Elektrode und Gegenelektrode mit elektrischem Potential
b Spannungsquelle zur Beaufschlagung von Elektrode und Gegenelektrode mit elektrischem Potential
- 16: gefaltete Membran
- 17: a und b: Elektrisch isolierende, permeable Trennfolie vor bzw. hinter der Membran

- 18: leitfähige äußere Hülse der Kartusche
- 19: leitfähige innere Hülse der Kartusche
- 20: Oberer Versschluss u. Prallplatte der Kartusche
- 21: Unterer Verschluss und Auslauf der Kartusche
- 22: Filtereinlauf und Filtergehäuse
- 23: Filterauslauf und Filtergehäuse
- 24: a Kontaktdurchführung zur elektrischen Kontaktierung der upstreamseitigen Metallisierung der Membran 16
b Kontaktdurchführung zur elektrischen Kontaktierung der downstreamseitigen Metallisierung der Membran 16
- 25: a Kontaktdurchführung und Gegenelektrode auf der upstream-Seite der metallisierten Membran 16
b Kontaktdurchführung zur elektrischen Kontaktierung der Gegenelektrode auf der downstream-Seite der metallisierten Membran 16
c Gegenelektrode auf der downstream-Seite der metallisierten Membran 16
- 26: a Spannungsquelle zur Beaufschlagung von Elektrode und Gegenelektrode mit elektrischem Potential
b Spannungsquelle zur Beaufschlagung von Elektrode und Gegenelektrode mit elektrischem Potential

## Patentansprüche

1. Verfahren zur temporären Separation von geladenen Substanzen in einer Flüssigkeit mittels Elektrosorption und/oder Elektrofiltration umfassend die folgenden Schritte
a. Bereitstellen einer Polymermembran mit flächiger und poröser Beschichtung aus Metall zumindest auf einer ersten Seite der Polymermembran;
b. Bereitstellen einer Gegenelektrode;
c. Anlegen einer Spannung zwischen der Beschichtung aus Metall der Polymermembran und der Gegenelektrode;
d. In Kontakt bringen der Polymermembran und der Gegenelektrode mit der Flüssigkeit, wobei das in Kontakt bringen der Art erfolgt, dass die Flüssigkeit eine Verbindung zwischen der Polymermembran und der Gegenelektrode erzeugt,
wobei die Polymermembran mit flächiger und poröser Beschichtung aus Metall und die Gegenelektrode in einem Gehäuse eingebracht sind und die zu filtrierende Flüssigkeit durch das Gehäuse geleitet wird,
wobei die Flüssigkeit aus einer Spritze an der Polymermembran mit flächiger und poröser Beschichtung aus Metall vorbei oder durch die Polymermembran mit flächiger und poröser Beschichtung aus Metall hindurch gedrückt wird, wobei die geladenen Substanzen temporär durch die Schritte a bis d durch Bindung an die Polymermembran adsorbieren und/oder zurückgehalten werden und
nach den Schritten a bis d ein Umpolen und/oder Verringern der Spannung und ein Spülen der Membran mit einer weiteren Flüssigkeit, insbesondere ein Durchführen der weiteren Flüssigkeit durch die Membran, insbesondere in zur Separation umgekehrter Fließrichtung, zur Abgabe der separierten Substanzen in die weitere Flüssigkeit erfolgt.

2. Verfahren nach Anspruch 1, wobei der Schritt c nach den Schritten a und b und vor Schritt d erfolgt oder wobei der Schritt d nach den Schritten a und b und vor Schritt c erfolgt.

3. Verfahren nach einem der vorstehenden Ansprüche, wobei das Gehäuse ein geringes Hold-Up Volumen, insbesondere von maximal 10 ml und/oder maximal 20 mm³/mm² Beschichtung aus Metall auf der Polymermembran, insbesondere maximal 2 mm³/mm² Beschichtung aus Metall auf der Polymermembran, aufweist.

4. Verfahren nach einem der vorstehenden Ansprüche, wobei die Flüssigkeit durch das Gehäuse durch Betätigen der Spritze gedrückt wird.

5. Verfahren nach einem der vorstehenden Ansprüche, wobei die Gegenelektrode entweder durch eine weitere flächige, poröse Beschichtung aus Metall auf einer zweiten, der ersten Seite gegenüberliegenden Seite gebildet wird, wobei die flächigen Beschichtungen aus Metall gegeneinander durch die Polymermembran isoliert sind, oder durch eine unter Zwischenlage eines isolierenden und permeablen Spacers angeordnete permeable Elektrode, insbesondere gebildet durch ein metallisches Netz, gebildet wird.

6. Verfahren nach einem der vorstehenden Ansprüche, **dadurch gekennzeichnet, dass** die Porosität der Polymermembran mit Beschichtung aus Metall bezogen auf die initiale Bubble Point Pore und/oder die mittlere Porengröße gegenüber der unbeschichteten Polymermembran zwischen 1 % und 50 %, insbesondere 1 und 20 % verringert ist.

7. Verfahren nach einem der vorstehenden Ansprüche, **dadurch gekennzeichnet, dass** die Dicke der Beschichtung aus Metall 5 bis 50nm beträgt und die Porengröße der unbeschichteten Polymermembran insbesondere größer als 0,01 *µ*m ist.

8. Verfahren nach einem der vorstehenden Ansprüche zur Bestimmung der Belegung der Bindungsplätze der Polymermembran mit flächiger und poröser Beschichtung aus Metall und/oder zur Bestimmung mindestens einer Konzentration in der Flüssigkeit, wobei der durch die angelegte Spannung bewirkte Stromfluss erfasst und/oder ausgewertet wird, insbesondere hinsichtlich der Unterschreitung einer Grenze und/oder der Überschreitung einer positiven und/oder negativen Änderungsrate ausgewertet wird und insbesondere bei Unterschreiten oder Überschreiten eine Alarmierung ausgelöst wird.

9. Elektrosorptions- und/oder Elektrofiltrationsvorrichtung beinhaltend mindestens eine Polymermembran (8) mit flächiger und poröser Beschichtung aus Metall auf zumindest einer Seite der Polymermembran und eine Kontaktierung der Beschichtung aus Metall und eine Gegenelektrode (10a, 10b, 12a, 12b) und insbesondere einer weiteren Elektrode,
wobei die Polymermembran und die Gegenelektrode in einem Gehäuse angeordnet sind, das als Spritzenvorsatz ausgebildet ist,
wobei das Gehäuse ein Hold-Up Volumen von maximal 10 ml und/oder maximal 20 mm³/mm² Beschichtung aus Metall auf der Polymermembranaufweist.

10. Elektrosorptions- und/oder Elektrofiltrationsvorrichtung nach Anspruch 9, wobei das Gehäuse ein Hold-Up Volumen von maximal 2 mm³/mm² Beschichtung aus Metall auf der Polymermembran aufweist.

11. Elektrosorptions- und/oder Elektrofiltrationsvorrichtung nach einem der Ansprüche 9 oder 10, wobei die Polymermembran und die Gegenelektrode mit einer Spannungsquelle (15a, 15b) verbunden sind, die eingerichtet ist eine Spannung zwischen Polymermembran und Gegenelektrode auszubilden und wobei insbesondere die Spannungsquelle mit der Polymermembran und der Gegenelektrode in einem gemeinsamen Gehäuse angeordnet ist und/oder eine Strommessvorrichtung vorgesehen ist, die den zwischen Polymermembran und Gegenelektrode fließenden Strom und/oder dessen Änderungsrate misst und/oder mit einem Grenzwert vergleicht und/oder die Spannungsquelle zum Umpolen und/oder Verringern der Spannung eingerichtet ist

12. Elektrosorptions- und/oder Elektrofiltrationsvorrichtung nach einem der Ansprüche 9 bis 11, wobei die Gegenelektrode entweder durch eine weitere flächige, poröse Beschichtung aus Metall auf einer zweiten, der ersten Seite gegenüberliegenden Seite gebildet wird oder durch eine unter Zwischenlage eines isolierenden und permeablen Spacers angeordnete permeable Elektrode, insbesondere gebildet durch ein metallisches Netz, gebildet ist.

13. Elektrosorptions- und/oder Elektrofiltrationsvorrichtung nach einem der Ansprüche 9 bis 12, **dadurch gekennzeichnet, dass** die Porosität der Polymermembran mit Beschichtung aus Metall bezogen auf die initiale Bubble Point Pore und/oder die mittlere Porengröße gegenüber der unbeschichteten Polymermembran zwischen 1 % und 50 %, insbesondere 1 und 20 % verringert ist.

14. Elektrosorptions- und/oder Elektrofiltrationsvorrichtung nach einem der Ansprüche 9 bis 13, **dadurch gekennzeichnet, dass** die Dicke der Beschichtung aus Metall 5 bis 50nm beträgt und die Porengröße der unbeschichteten Polymermembran insbesondere 0,01 µm bis 15 *µ*m beträgt.

## Claims

1. A method for the temporary separation of charged substances in a liquid by means of electrosorption and/or electrofiltration comprising the following steps
a. Providing a polymer membrane with a flat and porous coating of metal at least on a first side of the polymer membrane;
b. Providing a counter electrode;
c. Applying a voltage between the metal coating of the polymer membrane and the counter electrode;
d. Contacting the polymer membrane and the counter electrode with the liquid, the contacting being such that the liquid creates a bond between the polymer membrane and the counter electrode,
wherein the polymer membrane with a flat and porous coating of metal and the counter electrode are placed in a housing and the liquid to be filtered is passed through the housing, wherein the liquid is pressed from a syringe past the polymer membrane with a flat and porous coating of metal or through the polymer membrane with a flat and porous coating of metal, wherein the charged substances are temporarily adsorbed and/or retained by the steps a to d by binding to the polymer membrane and
after steps a to d, reversing the polarity and/or reducing the voltage and rinsing the membrane with a further liquid, in particular passing the further liquid through the membrane, in particular in the reverse flow direction to the separation, to release the separated substances into the further liquid.

2. A method according to claim 1, wherein step c takes place after steps a and b and before step d or wherein step d takes place after steps a and b and before step c.

3. A method according to one of the preceding claims, wherein the housing has a low hold-up volume, in particular of at most 10 ml and/or at most 20 mm³/mm² of metal coating on the polymer membrane, in particular at most 2 mm³/mm² of metal coating on the polymer membrane.

4. A method according to one of the preceding claims, wherein the liquid is forced through the housing by actuating the syringe.

5. A method according to one of the preceding claims, wherein the counter electrode is formed either by a further flat, porous coating of metal on a second side opposite the first side, wherein the flat coatings of metal are insulated from one another by the polymer membrane, or by a permeable electrode, in particular formed by a metallic mesh, arranged with an insulating and permeable spacer between them.

6. A method according to one of the preceding claims, **characterised in that** the porosity of the polymer membrane with metal coating is reduced by between 1 % and 50 %, in particular 1 % and 20 %, relative to the initial bubble point pore and/or the average pore size compared to the uncoated polymer membrane.

7. A method according to one of the preceding claims, **characterised in that** the thickness of the metal coating is 5 to 50 nm and the pore size of the uncoated polymer membrane is, in particular, greater than 0.01 µ/m.

8. A method according to one of the preceding claims for determining the occupancy of the binding sites of the polymer membrane with a flat and porous coating of metal and/or for determining at least one concentration in the liquid, wherein the current flow caused by the applied voltage is detected and/or analysed, in particular is analysed with regard to falling below a limit and/or exceeding a positive and/or negative rate of change and in particular an alarm is triggered when falling below or exceeding a limit.

9. An electrosorption and/or electrofiltration device comprising at least one polymer membrane (8) with a flat and porous coating of metal on at least one side of the polymer membrane and a contacting of the coating of metal and a counter electrode (10a, 10b, 12a, 12b) and in particular a further electrode,
wherein the polymer membrane and the counter electrode are arranged in a housing which is designed as a syringe attachment,
wherein the housing has a hold-up volume of maximum 10 ml and/or maximum 20 mm³/mm² of metal coating on the polymer membrane.

10. An electrosorption and/or electrofiltration device according to claim 9, wherein the housing has a hold-up volume of a maximum of 2 mm³/mm² of metal coating on the polymer membrane.

11. An electrosorption and/or electrofiltration device according to one of claims 9 or 10, wherein the polymer membrane and the counter electrode are connected to a voltage source (15a, 15b) which is arranged to form a voltage between the polymer membrane and the counter electrode and wherein, in particular, the voltage source is arranged with the polymer membrane and the counter electrode in a common housing and/or a current measuring device is provided, which measures the current flowing between the polymer membrane and the counter electrode and/or its rate of change and/or compares it with a limit value and/or the voltage source is set up to reverse the polarity and/or reduce the voltage.

12. An electrosorption and/or electrofiltration device according to one of claims 9 to 11, wherein the counter electrode is either formed by a further flat, porous coating of metal on a second side opposite the first side or is formed by a permeable electrode, in particular formed by a metallic mesh, arranged with an insulating and permeable spacer in between.

13. An electrosorption and/or electrofiltration device according to one of claims 9 to 12, **characterised in that** the porosity of the polymer membrane with metal coating is reduced by between 1 % and 50 %, in particular 1 % and 20 %, relative to the initial bubble point pore and/or the average pore size compared to the uncoated polymer membrane.

14. An electrosorption and/or electrofiltration device according to one of claims 9 to 13, **characterised in that** the thickness of the metal coating is 5 to 50 nm and the pore size of the uncoated polymer membrane is in particular 0.01 µm to 15 µm.

## Revendications

1. Procédé de séparation temporaire de substances chargées dans un liquide par électro-sorption et/ou électrofiltration, comprenant les étapes suivantes.
a. Fourniture d'une membrane polymère avec un revêtement plat et poreux de métal au moins sur un premier côté de la membrane polymère ;
b. Fourniture d'une contre-électrode ;
c. Application d'une tension entre le revêtement métallique de la membrane polymère et la contre-électrode ;
d. Mise en contact de la membrane polymère et de la contre-électrode avec le liquide, la mise en contact étant telle que le liquide crée une liaison entre la membrane polymère et la contre-électrode,
dans lequel la membrane polymère à revêtement métallique plat et poreux et la contre-électrode sont placées dans un boîtier et le liquide à filtrer passe à travers le boîtier, dans lequel le liquide est pressé à partir d'une seringue à travers la membrane polymère à revêtement métallique plat et poreux ou à travers la membrane polymère à revêtement métallique plat et poreux, dans lequel les substances chargées sont temporairement adsorbées et/ou retenues par les étapes a à d en se liant à la membrane polymère, et
après les étapes a à d, inverser la polarité et/ou réduire la tension et rincer la membrane avec un autre liquide, en particulier faire passer l'autre liquide à travers la membrane, en particulier dans le sens inverse de la séparation, pour libérer les substances séparées dans l'autre liquide.

2. Procédé selon la revendication 1, dans lequel l'étape c suit les étapes a et b et précède l'étape d ou dans lequel l'étape d suit les étapes a et b et précède l'étape c.

3. Procédé selon l'une des revendications précédentes, dans lequel le boîtier a un faible volume de retenue, en particulier d'au plus 10 ml et/ou d'au plus 20 mm³/mm² de revêtement métallique sur la membrane polymère, en particulier d'au plus 2 mm3/mm2 de revêtement métallique sur la membrane polymère.

4. Procédé selon l'une des revendications précédentes, dans lequel le liquide est injecté à travers le boîtier en actionnant la seringue.

5. Procédé selon l'une des revendications précédentes, dans lequel la contre-électrode est formée soit par un autre revêtement plat et poreux de métal sur une seconde face opposée à la première face, les revêtements plats de métal étant isolés l'un de l'autre par la membrane polymère, soit par une électrode perméable, notamment formée par une maille métallique, disposée avec une entretoise isolante et perméable entre elles.

6. Procédé selon l'une des revendications précédentes, **caractérisé en ce que** la porosité de la membrane polymère avec revêtement métallique est réduite de 1 % à 50 %, en particulier de 1 % à 20 %, par rapport au pore initial du point de bulle et/ou à la taille moyenne des pores par rapport à la membrane polymère non revêtue.

7. Procédé selon l'une des revendications précédentes, **caractérisé en ce que** l'épaisseur du revêtement métallique est comprise entre 5 et 50 nm et que la taille des pores de la membrane polymère non revêtue est, en particulier, supérieure à 0,01 µ/m.

8. Procédé selon l'une des revendications précédentes pour déterminer l'occupation des sites de liaison de la membrane polymère avec un revêtement plat et poreux de métal et/ou pour déterminer au moins une concentration dans le liquide, dans lequel le flux de courant provoqué par la tension appliquée est détecté et/ou analysé, en particulier est analysé en ce qui concerne le passage en dessous d'une limite et/ou le dépassement d'un taux de variation positif et/ou négatif et en particulier une alarme est déclenchée en cas de passage en dessous d'une limite ou de dépassement d'une limite.

9. Dispositif d'électrosorption et/ou d'électrofiltration comprenant au moins une membrane polymère (8) avec un revêtement plat et poreux de métal sur au moins un côté de la membrane polymère et une mise en contact du revêtement de métal et d'une contre-électrode (10a, 10b, 12a, 12b) et en particulier d'une autre électrode,
dans lequel la membrane polymère et la contre-électrode sont disposées dans un boîtier conçu comme un accessoire de seringue,
dans lequel le boîtier a un volume de rétention de maximum 10 ml et/ou de maximum 20 mm³/mm² de revêtement métallique sur la membrane polymère.

10. Dispositif d'électrosorption et/ou d'électrofiltration selon la revendication 9, dans lequel le boîtier a un volume de rétention d'un maximum de 2 mm³/mm² de revêtement métallique sur la membrane polymère.

11. Dispositif d'électrosorption et/ou d'électrofiltration selon l'une des revendications 9 ou 10, dans lequel la membrane polymère et la contre-électrode sont reliées à une source de tension (15a, 15b) qui est agencée pour former une tension entre la membrane polymère et la contre-électrode et dans lequel, en particulier, la source de tension est disposée avec la membrane polymère et la contre-électrode dans un boîtier commun et/ou un dispositif de mesure du courant est prévu, qui mesure le courant circulant entre la membrane polymère et la contre-électrode et/ou sa vitesse de variation et/ou le compare à une valeur limite et/ou la source de tension est réglée pour inverser la polarité et/ou réduire la tension.

12. Dispositif d'électrosorption et/ou d'électrofiltration selon l'une des revendications 9 à 11, dans lequel la contre-électrode est soit formée par un autre revêtement métallique plat et poreux sur une seconde face opposée à la première face, soit formée par une électrode perméable, notamment formée par une maille métallique, disposée avec une entretoise isolante et perméable entre les deux.

13. Dispositif d'électrosorption et/ou d'électrofiltration selon l'une des revendications 9 à 12, **caractérisé en ce que** la porosité de la membrane polymère à revêtement métallique est réduite de 1 % à 50 %, en particulier de 1 % à 20 %, par rapport au pore initial du point de bulle et/ou à la taille moyenne des pores par rapport à la membrane polymère non revêtue.

14. Dispositif d'électrosorption et/ou d'électrofiltration selon l'une des revendications 9 à 13, **caractérisé en ce que** l'épaisseur du revêtement métallique est comprise entre 5 et 50 nm et la taille des pores de la membrane polymère non revêtue est comprise notamment entre 0,01 µm et 15 µm.
